Europäisches Patentamt

European Patent Office

Office européen des brevets

(11) Veröffentlichungsnummer: **0 151 191**
A1

# (12) EUROPÄISCHE PATENTANMELDUNG

(21) Anmeldenummer: **84100741.2**

(22) Anmeldetag: **25.01.84**

(51) Int. Cl.⁴: **G 03 F 1/00**
**G 03 F 7/08**

Not applicable

(43) Veröffentlichungstag der Anmeldung:
**14.08.85** Patentblatt **85/33**

(84) Benannte Vertragsstaaten:
CH DE FR GB IT LI NL

(71) Anmelder: **AMERICAN HOECHST CORPORATION**
Route 202-206 North
Somerville, N.J. 08876(US)

(72) Erfinder: **Walls, John E.**
46, Center Street
Annandale, N.J. 08801(US)

(72) Erfinder: **Dhillon, Major S.**
896 Merrit Dr.
Hillsborough, N.J. 08876(US)

(74) Vertreter: **Euler, Kurt Emil, Dr. et al,**
KALLE Niederlassung der Hoechst AG Rheingaustrasse
190 Postfach 3540
D-6200 Wiesbaden 1(DE)

(54) Lichtempfindliches Material zur Herstellung von Kopiervorlagen.

(57) Es wird ein lichtempfindliches Material beschrieben, das aus einem Schichtträger und einer lichtempfindlichen Schicht besteht, die ein Farbmittel und eine negativ arbeitende lichthärtbare Diazoniumverbindung enthält, die eine Lichtabsorption im Spektralbereich von 360-390 nm von höchstens 45 % hat, gemessen in einer Lösung von 1 mg/100 ml. Die lichtempfindliche Schicht weist eine Lichtdurchlässigkeit von nicht mehr als 0,1 % im gleichen Spektralbereich auf und wird durch Ultraviolettbestrahlung einer Energie von 15 bis 25 mJ/cm² vollständig gehärtet. Das Material eignet sich besonders zur Herstellung von reprographischen Kopiervorlagen.

EP 0 151 191 A1

AMERICAN HOECHST CORPORATION
Somerville, N.J. 08876/USA

82/K 096                              WLK-Dr.N.-ur
                                      23. Januar 1984

Lichtempfindliches Material zur Herstellung von Kopiervorlagen

Die vorliegende Erfindung betrifft ein lichtempfindliches Kopiermaterial, das in seiner lichtempfindlichen Beschichtung keine Silberhalogenidverbindungen enthält.

Bei der Herstellung von Flachdruckformen ist es üblich, eine lichtempfindlich beschichtete Platte auf dem Wege der Kontaktbelichtung bzw. der Projektion durch eine photographische Vorlage mit einem Bild zu versehen. Normalerweise besteht eine solche Vorlage aus einem transparenten Träger, auf den eine lichtempfindliche Schicht aufgebracht wurde. Diese lichtempfindliche Schicht wird mit einem zu reproduzierenden Originalbild belichtet und anschließend entwickelt. Bei der großen Mehrzahl dieser photographischen Vorlagen dienen Halogensilberemulsionen als bilderzeugende Substanz. Die in letzter Zeit dramatisch angestiegenen Kosten für Silber haben bei den Benutzern dieser Kopiervorlagen den Wunsch nach einem Film aufkommen lassen, der die Vorzüge der Silberfilme aufweist, jedoch kein Silber enthält. Die Hersteller solcher Filme haben dieses Ziel zwar angestrebt und viele Alternativlösungen vorgeschlagen, doch diese sind für die Fachleute auf dem Gebiet der Druckplattenherstellung und -verwendung bisher noch nicht zufriedenstellend. Die Alternativvorschläge basieren auf Diazotypie- oder Photopolymersystemen. Solche Systeme haben jedoch schwerwiegende Nachteile in bezug auf die einwandfreie

AMERICAN HOECHST CORPORATION
Somerville, N.J. 08876/USA

- 2 -

optische Dichte, die Lichtempfindlichkeit, die Entwicklungsgeschwindigkeit, die Entwicklereigenschaften und
die Undurchlässigkeit gegenüber UV-Strahlung nach dem
Belichten und Entwickeln. Aus diesen Gründen und auch,
weil sie wegen ihrer Farbe und hohen Durchlässigkeit
für sichtbares Licht nicht ästhetisch ansprechend wirken, werden diese Filme in erster Linie als Prüf- und
Duplizierfilme eingesetzt, und nicht als Kontaktkopiervorlagen mit hoher optischer Dichte, die für die Belichtung von Druckplatten verwendet werden können.

In der GB-A 1 313 777 sind Farbprüffolien beschrieben,
deren lichtempfindliche Schicht ein Diazoniumsalz-Polykondensationsprodukt und mindestens einen Farbstoff enthält, der einer der drei Grundfarben des Mehrfarbendrucks
entspricht oder schwarz ist. Die optische Dichte dieser
Materialien reicht für eine Kopiervorlage für die Druckplattenbelichtung nicht aus.

Die Bildschicht von Kopiervorlagen muß eine optische
Dichte haben, die ausreicht, um den Durchgang von Licht
und damit die unbeabsichtigte Belichtung des darunterliegenden lichtempfindlichen Materials zu verhindern. Je
nach dessen Lichtempfindlichkeit kann eine höhere oder
geringere Dichte erforderlich sein. Eine Dichte von 1
bedeutet, daß 90 % des einfallenden Lichts absorbiert und
10 % durchgelassen werden. Eine Dichte von 2 bedeutet,
daß 99 % des Lichts zurückgehalten und nur 1 % durchgelassen werden. Im allgemeinen gilt eine Dichte von 3 als
Mindestwert für eine Kopiervorlage.

AMERICAN HOECHST CORPORATION
Somerville, N.J. 08876/USA

- 3 -

Die Kopiervorlage muß zunächst richtig bebildert werden.
Dabei wird normalerweise das lichtempfindliche Material,
aus dem die Vorlage hergestellt wird, in einer Kamera mit
dem wiederzugebenden Bild belichtet.

Das belichtete Material wird dann entwickelt. Dabei wird
ein negatives Transparentbild erhalten, wenn nicht als
Vorlage ein Negativ verwendet wurde. Wenn eine positive
Kopiervorlage erforderlich ist, wird von dem Negativbild
eine weitere Kopie gemacht und ebenfalls entwickelt.

Der entwickelte und getrocknete Film wird dann Schicht
auf Schicht auf die Druckplatte gelegt und das Ganze
belichtet.

Aufgabe der Erfindung war es daher, ein lichtempfindliches Material mit hoher optischer Dichte vorzuschlagen, dessen Lichtempfindlichkeit hoch genug ist, um es
innerhalb einer für die praktische Anwendung annehmbaren
Zeit belichten zu können. Das Material soll ferner in
den nicht vom Entwickler entfernten Bereichen opak genug
sein, um UV-Strahlung in ausreichendem Maße zurückzuhalten, wenn es als Kontaktkopiervorlage für Flachdruckplatten verwendet wird.

Gegenstand der Erfindung ist ein lichtempfindliches
Material, bestehend aus einem Schichtträger und einer
lichtempfindlichen Schicht, die eine negativ arbeitende
lichthärtbare Diazoniumverbindung und ein Farbmittel
enthält. Das erfindungsgemäße Material ist dadurch

AMERICAN HOECHST CORPORATION
Somerville, N.J. 08876/USA

- 4 -

gekennzeichnet, daß die Diazoniumverbindung eine Lichtabsorption im Spektralbereich von 360-390 nm von höchstens 45 % hat, gemessen in einer Lösung von 1 mg/100 ml, daß die lichtempfindliche Schicht eine Lichtdurchlässigkeit von nicht mehr als 0,1 % im gleichen Spektralbereich aufweist und daß die Schicht durch Ultraviolettbestrahlung einer Energie von 15 bis 25 mJ/cm$^2$ vollständig gehärtet wird.

Die in dem Material verwendeten Farbstoffe sind zur Belichtung und Härtung der Bildstellen ausreichend UVdurchlässig. Nach dem Entwickeln sind die entstandenen Bilder dagegen so undurchlässig gegenüber UV-Licht, daß sie zum fachgerechten Belichten von handelsüblichen Druckplatten und Duplizierfilmen verwendet werden können. Im Gegensatz zu den mit Photopolymeren und Diazokupplern arbeitenden Produkten aus dem Stand der Technik, die mit 100 bis 200 mJ/cm$^2$ belichtet werden müssen, erlaubt die Lichtempfindlichkeit des erfindungsgemäßen Films die Belichtung mit etwa 25 mJ/cm$^2$. Entwickelt wird nicht wie bei den Diazokupplern mit Ammoniakdampf, sondern mit einem flüssigen Entwickler, zum Beispiel mit einer wäßrig-alkalischen Lösung. Die Auflösung entspricht den technischen Anforderungen, wie sie z.B. beim Zeitungsdruck gestellt werden. Es können schwarze Filme hergestellt werden, die den derzeit für diese Zwecke verwendeten Silberfilmen sehr ähnlich sind.

AMERICAN HOECHST CORPORATION
Somerville, N.J. 08876/USA

- 5 -

Bei der Herstellung des erfindungsgemäßen photographischen Materials wird vorzugsweise ein transparenter
Träger verwendet. Im Rahmen der Erfindung sind geeignete
Trägermaterialien z.B. Aluminium, Polyester, Polystyrol,
Polyamid, Polycarbonat, Polypropylen, sowie Celluloseacetatfolien, Glas, metallbeschichtete transparente Materialien und ähnliche Materialien. Vorzugsweise besteht der
Träger aus einem Polyester, z.B. Polyethylenterephthalat.
Besonders gut geeignete Polyester sind beispielsweise
Hostaphan 4500 (American Hoechst Corporation), Melinex
305 und 505 (ICI) und Mylar (DuPont).

Auf einen solchen Träger wird eine lichtempfindliche
Schicht aus mindestens einer Diazoniumverbindung, einem
Harz und einem Farbmittel aufgebracht. Gegebenenfalls
kann die lichtempfindliche Masse noch weitere Bestandteile, z.B. Weichmacher, Tenside, Verlaufmittel, Mittel
zur Verbesserung der Entwickelbarkeit und andere für die
Herstellung solcher lichtempfindlichen Materialien
geeignete bekannte Bestandteile enthalten, die die
Lichtempfindlichkeit und -durchlässigkeit des Materials
nicht in nennenswertem Maße beeinträchtigen. Ebenso
werden zum Auflösen der genannten Bestandteile vor
dem Auftragen auf den Träger verträgliche Lösemittel
verwendet.

Bei der Herstellung des lichtempfindlichen Beschichtungsgemischs nach dieser Erfindung ist das Farbmittel äußerst
wichtig für die richtige Farbschattierung und eine genügende optische Dichte. Für eine Kontaktkopiervorlage,

AMERICAN HOECHST CORPORATION
Somerville, N.J. 08876/USA

- 6 -

die für die Belichtung von Druckplatten verwendet werden
soll, ist z.B. eine Dichte von 2,0 nicht ausreichend,
was für eine Vorlage zur Herstellung von Duplizierfilmen
durchaus der Fall ist. Bei einer Dichte von 2,0 werden
99 % des Lichtes zurückgehalten. Die durchgelassene
Lichtmenge von 1 % würde jedoch bei der Belichtung von
Druckplatten den Bildhintergrund beeinträchtigen. Für
diesen Zweck benötigt man eine Dichte von mindestens
3,0. Bevorzugt wird ein Farbstoffgemisch, durch das
der gewünschte Spektralausschnitt im UV-Bereich in
etwa auf den Bereich von 360-390 nm eingeengt wird.

Ein Gemisch eines gelben, roten und blauen Farbstoffs in
entsprechender Menge ergibt den gewünschten Effekt. Die
am meisten bevorzugte Farbstoffzusammensetzung besteht
aus Calcozingelb, Rhodamin 6 GDN (rot) und Viktoriablau
FGA. Auch Zusammensetzungen aus folgenden Farbstoffen
werden bevorzugt verwendet: Auramin, Acridingelb, Methylorange, Naphtholgrün, Methylthymolblau, Phenolrot, Calcozinschwarz CBF, Basic Black W-113 und Pena-Farbstoffe. Die
Erfindung verwendet eine Farbmittelzusammensetzung, die
eine Rußdispersion enthält oder einen Farbstoff oder ein
Farbstoffgemisch mit einer Lichtdurchlässigkeit von
höchstens 0,1 % im Spektralbereich von 350-390 nm.

Erfindungsgemäß werden am besten die extrem lichtempfindlichen Diazoniumverbindungen verwendet, die im Bereich
von 350 bis 390 nm, vorzugsweise von 360 bis 380 nm eine
Absorption von höchstens 45 % aufweisen, wenn die Absorption z.B. mit einem in sichtbaren und im UV-Bereich

AMERICAN HOECHST CORPORATION
Somerville, N.J. 08876/USA

- 7 -

arbeitenden Perkin-Elmer Spektrophotometer (Modell 559) unter normalen Prüfbedingungen gemessen wird. Die Diazoniumverbindung kann aus einer oder mehreren Diazoniumverbindungen bestehen, die allein oder zusammen mit einem ausgewählten Sensibilisator verwendet werden. Für den erfindungsgemäßen Einsatz muß die Diazoniumverbindung den folgenden Test bestehen:

Testverfahren

0,001 g der zu prüfenden Diazoniumverbindung werden in 100 ml Ethylenglykolmonomethylether gelöst. Zunächst wird in beide Küvetten des Spektrophotometers Ethylenglykolmonomethylether eingefüllt und das Gerät bei einer Wellenlänge von 368 nm auf Null eingestellt. Anschließend wird der Ethylenglykolmonomethylether aus einer der Küvetten gegen die Testlösung ausgetauscht und die Lichtabsorption der Lösung gemessen. Die Testlösung ist annehmbar, wenn sie eine Absorption von höchstens etwa 45 % aufweist. Gegebenenfalls können auch andere Lösemittel als Ethylenglykolmonomethylether verwendet werden.

Bevorzugt sollte die Lichtabsorption zwischen etwa 25 % und 40 % liegen. Die erfindungsgemäß bevorzugten Diazoniumverbindungen sind das Kondensationsprodukt aus 4,4'-Bis-methoxymethyl-diphenylether und 3-Methoxy-diphenylamin-4-diazoniumsulfat, ausgefällt als Mesitylensulfonat, sowie das Produkt aus der Kondensation des Homokondensats von 4,4'-Bis-methoxymethyl-diphenylether mit 3-Methoxy-diphenylamin-4-diazoniumsulfat, ausgefällt

AMERICAN HOECHST CORPORATION
Somerville, N.J. 08876/USA

- 8 -

als Mesitylensulfonat. Bevorzugte, als Bestandteil der Diazoniumverbindung geeignete Sensibilisatoren sind substituierte Amino- und Azoverbindungen. Solche Verbindungen sind zum Beispiel die primären, sekundären und tertiären Amine, und von diesen sind wiederum Diphenylamin, Triphenylamin, 4-Phenylazo-diphenylamin, o-Tolylazo-toluidin, t-Butyldiethanolamin und 1-Methyl-2-(2'-hydroxyphenyl)-benzimidazol bevorzugt. Weitere geeignete Sensibilisatoren sind Phenole und mehrwertige Alkohole, die in geeigneter Menge den Löslichkeitsunterschied zwischen belichteten und unbelichteten Bereichen bei der bildmäßigen Belichtung solcher Diazoniumverbindungen mit UV-Strahlung erhöhen können. Die am meisten bevorzugten Verbindungen dieser Art sind zum Beispiel: Phenol, Resorcin, Brenzcatechin, Phloroglucin, Pentaerythrit, 4,4'-Dihydroxy-diphenyl, 3-Methoxyphenol, 1,2-Bis-(3-hydroxyphenoxy)ethan, 2,6-Resorcylsäure, p-Phenylazophenol, 4-(p-Nitrophenylazo)-resorcin und 4-Brom-3,5-resorcylsäure.

Weitere geeignete Sensibilisatoren sind Bis(2-hydroxynaphth-1-yl)sulfid, Diresorcylsulfid, Diphenylsulfon, Phenothiazin, Bis-benzothienylsulfon, N-(3-Hydroxyphenyl)-2-hydroxy-3-naphthoesäureamid, 2-hydroxy-3-naphthoesäure-ethanolamid, N,N'-Bis-acetoacetyl-ethylendiamin, 4-Brom-3,5-resorcylsäureamid sowie die analogen Schwefelverbindungen, Amidoverbindungen und Schwefelamidoverbindungen.

AMERICAN HOECHST CORPORATION
Somerville, N.J. 08876/USA

- 9 -

Diese Sensibilisatoren sind in der EP-A 89 506 und den
DE-A 33 06 943 und 33 07 037 beschrieben.

In der erfindungsgemäßen Beschichtung ist vorzugsweise
auch ein Harz als Bindemittel enthalten. Das Harz verhilft zur Bildung einer festen und stabilen Matrix, die
unempfindlich gegen Handhabung ist und eine feste Haftung
auf dem Träger bewirkt. Das Harz soll vorzugsweise saure
funktionelle Gruppen aufweisen, so daß es in einer
wäßrig-alkalischen Lösung entfernt werden kann. Das bevorzugte Bindemittel ist ein Copolymeres aus Styrol und
Maleinsäureanhydrid. Weitere geeignete Bindemittel sind
z. B. Copolymere aus Methylmethacrylat und Methacrylsäure, aus Methylvinylether und Maleinsäureanhydrid,
aus Styrol und Methacrylsäure und aus Methacrylsäure und
Acrylsäure.

Die Beschichtung kann gegebenenfalls auch noch ein
wasserlösliches Polymeres enthalten, das als Verlaufmitel
für die Beschichtung dient und bestimmte Unregelmäßigkeiten in der Beschichtung beseitigen kann. Bevorzugt
wird für diesen Zweck Hydroxyisopropylcellulose. Weitere
geeignete Polymere sind Methylcellulose, Hydroxyethylcellulose, Carboxymethylhydroxyethylcellulose, Polyvinylalkohol, Polyvinylpyrrolidon und Copolymere aus
Vinylalkohol und Vinylacetat.

In der Beschichtung gegebenenfalls enthaltene Weichmacher
vermindern die Sprödigkeit und erhöhen die Flexibilität
der Schicht. Geeignete Weichmacher sind z. B. Dimethylphthalat, Dibutylphthalat und Dioctylphthalat.

AMERICAN HOECHST CORPORATION
Somerville, N.J. 08876/USA

- 10 -

Die Beschichtung kann ferner Säuren als Stabilisatoren enthalten, die die Entwickelbarkeit unterstützen und die Lagerfähigkeit des Materials verbessern. Gute Stabilisatoren sind z.B. Arylsulfon- und -disulfonsäuren. Beispiele für geeignete Säuren sind p-Toluolsulfonsäure, Benzolsulfonsäure, Mesitylensulfonsäure, Naphthalinsulfonsäure, Citronensäure, Weinsäure und Phosphorsäure.

Zur Herstellung der Beschichtungsmasse wird eine geeignete Lösemittelkombination verwendet, in der sich die vorgenannten Bestandteile auflösen lassen. Nachdem die Beschichtungsmasse auf den Träger aufgebracht wurde, wird sie getrocknet, und dabei werden die Lösemittel weitestgehend wieder entfernt. Lösemittel, die für mindestens eine der obengenannten Komponenten geeignet sind, sind z.B. Wasser, Alkohole, wie Ethanol, Methanol, n-Propanol und Isopropanol; Ether, z.B. 2-Methoxyethanol, 2-Methoxyethylacetat, 2-Ethoxyethanol, 2-Ethoxyethylacetat und 2-Butoxyethanol und ferner Ketone, wie Methylethylketon, Diethylketon, Methylisobutylketon, Diisobutylketon, Diisopropylketon und Methylisopropylketon.

Zur Herstellung der erfindungsgemäßen Beschichtungsmassen können die einzelnen Bestandteile in den folgenden Mengenanteilen verwendet werden. Alle Mengen sind in Gewichtsprozent, bezogen auf die feste getrocknete Beschichtung, angegeben.

AMERICAN HOECHST CORPORATION
Somerville, N.J. 08876/USA

- 11 -

| Bestandteil | vorteilhafter Bereich | | bevorzugter Bereich | | insbesondere bevorzugter Bereich | |
|---|---|---|---|---|---|---|
| Diazonium-verbindung | 10 | - 70 | 20 | - 65 | 45 | - 60 |
| Harz als Bindemittel | 1 | - 35 | 5 | - 25 | 10 | - 25 |
| Farbmittel | 0,3 | - 40 | 2,5 | - 40 | 10 | - 35 |

Die Mengenanteile der wahlweise in der Beschichtung verwendeten Bestandteile liegen in folgenden Bereichen:

| Bestandteil | vorteilhafter Bereich | | bevorzugter Bereich | | insbesondere bevorzugter Bereich | |
|---|---|---|---|---|---|---|
| Stabilisator | 0,05 | - 15 | 0,1 | - 10 | 1 | - 5 |
| Sensibili-sator | 0,05 | - 15 | 0,1 | - 10 | 1 | - 5 |
| wasserlös-liches Polymeres | 0,001 | - 15 | 0,1 | - 10 | 0,5 | - 5 |

Die Erfindung wird nachfolgend durch Beispiele erläutert:

Beispiel 1
Auf eine 45 x 45 cm große Probe einer transparenten Polyesterfolie wird die folgende Beschichtungslösung aufgeschleudert:

AMERICAN HOECHST CORPORATION
Somerville, N.J. 08876/USA

- 12 -

26,3 Gew.-% 2-Methoxyethanol,
34,4 " " Butanon,
25,5 " " Ethanol (wasserfrei),
0,4 " " Dimethylphthalat,
0,3 " " p-Toluolsulfonsäure,
1,9 " " Styrol/Maleinsäureanhydrid-Copolymer,
0,4 " " Hydroxyisopropylcellulose,
1,6 " " Calcozingelb,
0,6 " " Rhodamin 6 GDN,
0,6 " " Viktoriablau FGA,
8,0 " " Diazoniumverbindung

Die Diazoniumverbindung ist das Produkt aus der Umsetzung des Homokondensationsprodukts von 4,4-Bis-methoxymethyl-diphenylether mit 3-Methoxydiphenylamin-4-diazoniumsulfat, ausgefällt als Mesitylensulfonat.

Die beschichtete Folie wird 2 Minuten auf 100°C erwärmt; dabei werden die Lösemittelreste aus der Beschichtung vertrieben. Anschließend wird mit einer Quecksilberdampflampe unter einer Testmontage und durch einen 21-stufigen Stauffer-Stufenkeil (Schicht auf Schicht) belichtet, wobei jede höhere Stufe des Stufenkeils eine Dichtezunahme um den Faktor 2 bedeutet. Der Testfilm wird mit 40 mJ/cm$^2$ belichtet und anschließend mit einer wäßrig-alkalischen Entwicklerlösung entwickelt, die Metallsalze von Phosphorsäure und Kieselsäure enthält. Die entwickelte Kontaktkopiervorlage weist zwei vollständig gedeckte und zwei teilgedeckte Keilstufen auf und hat außerdem einen völlig desensibilisierten Nichtbildbereich.

AMERICAN HOECHST CORPORATION
Somerville, N.J. 08876/USA

- 13 -

Beispiel 2
Beispiel 1 wird wiederholt, wobei allerdings die verwendete Diazoniumverbindung das Kondensationsprodukt aus 4,4'-Bis-methoxymethyl-diphenylether und 3-Methoxy-diphenylamin-4-diazoniumsulfat, ausgefällt als Mesitylensulfonat, ist. Diese und gleichartige Diazoniumverbindungen sind aus der US-A 3 849 392 bekannt.

Die beschichtete Folie wird wie in Beispiel 1 verarbeitet und weist nach dem Entwickeln eine vollständig gedeckte und zwei teilgedeckte Keilstufen auf.

Beispiel 3
Beispiel 1 wird wiederholt, wobei allerdings hier als Diazoniumverbindung das Kondensationsprodukt aus Diphenylamin-4-diazoniumsulfat und Paraformaldehyd, ausgefällt als Hexafluorophosphat, verwendet wird. Diese Diazoniumverbindung wird unter dem Handelsnamen "Diazo BBP" von der Firma MRI, Hightstown, N.J., USA, verkauft.

Die beschichtete Folie wird wie in Beispiel 1 verarbeitet und weist nach dem Entwickeln keine vollständig gedeckte und eine teilgedeckte Keilstufe auf. Das resultierende Bild ist technisch unzureichend.

Beispiel 4
Beispiel 2 wird wiederholt. In diesem Fall wird die Beschichtungslösung allerdings mit 5 g der Diazoniumverbindung aus Beispiel 2 hergestellt. Die beschichtete

AMERICAN HOECHST CORPORATION
Somerville, N.J. 08876/USA


- 14 -


Folie wird entsprechend Beispiel 1 verarbeitet und weist nach dem Entwickeln eine vollständig gedeckte und eine teilgedeckte Keilstufe auf.


Beispiel 5
Beispiel 1 wird wiederholt. Das als Bindemittel verwendete Harz ist hier jedoch ein Copolymeres aus Methylmethacrylat und Methacrylsäure. Die beschichtete Folie wird wie in Beispiel 1 beschrieben verarbeitet. Nach dem Entwickeln zeigen sich zwei vollständig gedeckte und zwei teilgedeckte Keilstufen.


Beispiel 6
Beispiel 2 wird wiederholt mit dem Unterschied, daß 1 g Morfast-Schwarz 101 (ein schwarzer Kobalt-Azofarbstoff von der Firma Morton Chemical Co., Chicago, Ill., USA) anstelle von Calcozingelb, Rhodamin 6 GDN und Viktoriablau FGA verwendet wird. Nach dem Entwickeln entsprechend der Methode aus Beispiel 1 weist die Kontaktkopiervorlage zwei vollständig gedeckte und zwei teilgedeckte Keilstufen auf.


Beispiel 7
Beispiel 2 wird wiederholt, wobei in diesem Beispiel der Beschichtungslösung 5 g Morfast-Schwarz 101 als Farbstoff zugemischt werden. Die Lösung wird auf einen Träger aus Polyesterfolie aufgeschleudert. Die beschichtete Folie wird nach der Methode aus Beispiel 1 verarbeitet, wobei die entwickelte Kontaktkopiervorlage eine vollständig gedeckte und vier teilgedeckte Keilstufen ergibt.

AMERICAN HOECHST CORPORATION
Somerville, N.J. 08876/USA

- 15 -

Beispiel 8

Beispiel 1 wird wiederholt; in diesem Fall wird jedoch Acridingelb als gelber Farbstoff verwendet. Nach dem Entwickeln entsprechend Beispiel 1 weist die Kontaktkopiervorlage zwei vollständig gedeckte und zwei teilgedeckte Keilstufen auf.

Beispiel 9

Beispiel 2 wird wiederholt, wobei hier jedoch Auramin anstelle von Calcozingelb verwendet wird. Die nach der Methode aus Beispiel 1 entwickelte Kontaktkopiervorlage zeigt eine vollständig gedeckte und zwei teilgedeckte Keilstufen.

Beispiel 10

50 g der Beschichtungslösung aus Beispiel 1 werden mit 2-Methoxyethanol auf 100 g verdünnt. Diese Lösung wird auf eine Polyesterfolie aufgeschleudert. Die beschichtete Folie wird nach der Methode aus Beispiel 1 verarbeitet und ergibt zwei vollständig gedeckte und eine teilgedeckte Keilstufe.

Die optischen Dichten der beschichteten Folien aus den Beispielen 1 bis 10 werden mit einem "Gretag D-3 Transmission Densitometer" mit schwarzen, blauen, roten und grünen Filtern gemessen. Die Meßergebnisse sind wie folgt:

AMERICAN HOECHST CORPORATION
Somerville, N.J. 08876/USA

- 16 -

| Beispiel | Optische Dichte | | | |
| | Filter | | | |
| | schwarz | blau | grün | rot |
|---|---|---|---|---|
| 1 | 3,20 | 3,87 | 4,10 | 2,80 |
| 2 | 3,20 | 3,87 | 4,10 | 2,80 |
| 3 | - | - | - | - |
| 4 | 1,14 | 1,88 | 1,65 | 1,01 |
| 5 | 3,20 | 3,80 | 4,15 | 2,85 |
| 6 | 1,75 | 1,82 | 1,65 | 1,55 |
| 7 | 3,35 | 3,96 | 4,20 | 2,85 |
| 8 | 3,20 | 3,85 | 4,10 | 2,80 |
| 9 | 3,15 | 3,75 | 4,10 | 2,75 |
| 10 | 1,80 | 2,75 | 2,65 | 1,60 |

Die Beispiele 1, 2, 5, 7, 8 und 9 weisen ein Produkt mit den erfindungsgemäß angestrebten Eigenschaften aus. Die Diazoniumverbindung in Beispiel 3 hat eine hohe, außerhalb des festgesetzten Maximalwerts liegende Absorption, und der damit hergestellte Film hat eine so geringe Lichtempfindlichkeit, daß nach dem Belichten kein Bild zu sehen ist. Beispiel 4 zeigt, daß eine reichliche Menge an Diazoniumverbindung erforderlich ist, denn in diesem Fall führt eine gegenüber Beispiel 2 um 37,5 % verminderte Menge an Diazoniumverbindung zu einem Film mit unzureichender Dichte. In Beispiel 6 wird nur ein einziger Farbstoff verwendet im Gegensatz zu dem System aus drei Farbstoffen, das in den vorangegangenen Beispielen eingesetzt wird, und es entsteht so ein Produkt mit zu geringer Dichte. In Beispiel 7 wird mit dem gleichen Farbstoff, jedoch in der fünffachen Menge gearbeitet. In

AMERICAN HOECHST CORPORATION
Somerville, N.J. 08876/USA

- 17 -

diesem Fall bleibt die Lichtempfindlichkeit noch annehmbar, und die Kopiervorlage hat auch die gewünschte Dichte. Beispiel 10 wiederholt Beispiel 1, jedoch mit einem Feststoffgehalt, der durch Verdünnen um 50 % vermindert ist. Ein solcher Film ist aufgrund seiner unzureichenden Dichte nicht brauchbar.

In Beispiel 1 wird eine Diazoniumverbindung mit hoher Lichtempfindlichkeit verwendet, die der in Beispiel 2 verwendeten, geringer lichtempfindlichen Diazoniumverbindung ähnlich ist. Trotz eines leichten Unterschieds bei den erreichten Keilstufen ergeben beide Diazoniumverbindungen eine annehmbare Dichte. Die Beispiele 8 und 9 entsprechen den Beispielen 1 und 2 mit dem Unterschied, daß sie ein anderes, jedoch gleichfalls brauchbares Farbstoffsystem verwenden. Beispiel 5, das mit einem anderen möglichen Harz als Bindemittel durchgeführt wird, bringt die gleichen guten Ergebnisse wie Beispiel 1.

AMERICAN HOECHST CORPORATION
Somerville, N.J. 08876/USA

82/K 096                    - 18 -                    WLK-Dr.N.-ur
                                                      23. Januar 1984


Patentansprüche


1.    Lichtempfindliches Material, bestehend aus einem
Schichtträger und einer lichtempfindlichen Schicht, die
eine negativ arbeitende lichthärtbare Diazoniumverbindung
und ein Farbmittel enthält, dadurch gekennzeichnet, daß
die Diazoniumverbindung eine Lichtabsorption im Spektralbereich von 360-390 nm von höchstens 45 % hat, gemessen
in einer Lösung von 1 mg/100 ml, daß die lichtempfindliche Schicht eine Lichtdurchlässigkeit von nicht mehr
als 0,1 % im gleichen Spektralbereich aufweist und daß
die Schicht durch Ultraviolettbestrahlung einer Energie
von 15 bis 25 mJ/cm$^2$ vollständig gehärtet wird.


2.    Lichtempfindliches Material nach Anspruch 1, dadurch gekennzeichnet, daß der Schichtträger transparent
ist.


3.    Lichtempfindliches Material nach Anspruch 1, dadurch gekennzeichnet, daß die Diazoniumverbindung ein
Polykondensationsprodukt eines Diphenylamin-4-diazonium-
salzes ist.


4.    Lichtempfindliches Material nach Anspruch 3, dadurch gekennzeichnet, daß die Diazoniumverbindung ein
Polykondensationsprodukt eines 3-Methoxy-diphenylamin-
4-diazoniumsalzes mit 4,4'-Bis-methoxymethyl-diphenyl-
ether ist.

AMERICAN HOECHST CORPORATION
Somerville, N.J. 08876/USA

- 19 -

5. Lichtempfindliches Material nach Anspruch 1, dadurch gekennzeichnet, daß die Schicht ferner ein polymeres Bindemittel enthält.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int Cl 4) |
|---|---|---|---|
| X | US-A-3 679 419 (T.N. GILLICH) * Spalte 7, Zeilen 36-54, 6-19; Spalte 9, Zeilen 33-36; Spalte 10, Zeilen 38-42; Ansprüche * | 1-5 | G 03 F 1/00 G 03 F 7/08 |
| X | PATENTS ABSTRACTS OF JAPAN, Band 7, Nr. 150(P-207)(1295), 30. Juni 1983; & JP - A - 58 60737 (TOYO BOSEKI K.K.) 11.04.1983 | 1 | |
| X | EP-A-0 096 326 (AMERICAN HOECHST) * Seite 4, Zeilen 22-26; Seite 6, Zeilen 3-7; Ansprüche * | 1-5 | |
| X | EP-A-0 061 150 (AMERICAN HOECHST) * Zusammenfassung; Seite 22, Zeilen 11-15; Seite 25, Zeilen 8-16 * | 1-5 | |
| X | GB-A-1 525 757 (OCE-VAN DER GRINTEN) * Seite 4, Zeilen 17-36 * | 1 | RECHERCHIERTE SACHGEBIETE (Int. Cl 4) G 03 F 1/00 G 03 F 7/08 |
| X,D | GB-A-1 313 777 (AROPLATE) * Insgesamt * | 1-5 | |
| A | EP-A-0 017 563 (RHONE POULENC) * Seite 9, Zeile 26 - Seite 10, Zeile 11; Beispiel 13 * | 1-5 | |

--- -/-

Der vorliegende Recherchenbericht wurde für alle Patentansprüche erstellt.

| Recherchenort DEN HAAG | Abschlußdatum der Recherche 02-10-1984 | Prüfer RASSCHAERT A. |
|---|---|---|

KATEGORIE DER GENANNTEN DOKUMENTEN

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03.82

**0151191**
Nummer der Anmeldung

**EUROPÄISCHER RECHERCHENBERICHT**

Europäisches
Patentamt

EP 84 10 0741

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | EP-A-0 061 319 (SENSITISERS RESEARCH)<br>* Zeilen 1-5 *<br><br>-----| | |

Der vorliegende Recherchenbericht wurde für alle Patentansprüche erstellt.

RECHERCHIERTE
SACHGEBIETE (Int. Cl.4)

| Recherchenort<br>DEN HAAG | Abschlußdatum der Recherche<br>02-10-1984 | Prüfer<br>RASSCHAERT A. |
|---|---|---|